# FASCICULE DE BREVET EUROPEEN

(11) **EP 3 171 395 B1**
(45) Date de publication et mention de la délivrance du brevet: **29.08.2018**
(21) Numéro de dépôt: 16200058.2
(22) Date de dépôt: 22.11.2016
(51) Int. Cl.: H01L 21/60, H01L 21/768

(54) **REALISATION D'INTERCONNEXIONS PAR RECOURBEMENT D'ELEMENTS CONDUCTEURS SOUS UN DISPOSITIF MICROELECTRONIQUE TEL QU'UNE PUCE**
HERSTELLUNG VON VERBINDUNGEN DURCH UMBIEGEN VON LEITERELEMENTEN UNTER EINE MIKROELEKTRONISCHE VORRICHTUNG WIE EINEN CHIP
FORMATION OF INTERCONNECTIONS BY CURVING CONDUCTIVE ELEMENTS UNDER A MICROELECTRONIC DEVICE SUCH AS A CHIP

(30) Priorité: 23.11.2015 FR 1561241
(43) Date de publication de la demande: 24.05.2017
(73) Titulaire: COMMISSARIAT À L'ÉNERGIE ATOMIQUE ET AUX ÉNERGIES ALTERNATIVES, 75015 Paris (FR)
(72) Inventeur: BOREL, Stephan, 38920 CROLLES (FR)
(74) Mandataire: Brevalex

(56) Documents cités:
- WO-A1-2011/126726
- US-A1- 2004 157 410
- US-A1- 2008 274 603
- US-A1- 2009 051 046
- US-A1- 2010 317 153

## Description

### DOMAINE TECHNIQUE ET ART ANTÉRIEUR

Il existe plusieurs manières de connecter un dispositif microélectronique tel qu'une puce à un autre support doté de plots conducteurs, parmi elles :
- les techniques de connexion de type « wire bonding » (en français : « micro-câblage ») pour lesquelles une puce et un support sont collés l'un à l'autre puis connectés par le biais de fils conducteurs ;
- les techniques de connexions de type « flip-chip » pour lesquelles la puce est retournée afin de mettre des plots conducteurs disposés sur sa face avant en contact avec le support.

Une autre méthode pour connecter des plots 33 situés sur la face avant d'une puce 34 avec ceux 31 disposés sur la face avant d'un autre support 32 sans avoir à retourner celle-ci, consiste à mettre en oeuvre des éléments d'interconnexion 35 traversant l'épaisseur de la puce. La fabrication de ces éléments d'interconnexion communément appelés TSV (pour « Trough Silicon Vias ») comprend la formation de trous traversant toute l'épaisseur de la puce, puis une isolation des flancs latéraux des trous, puis une métallisation des trous.

Un inconvénient d'un tel procédé réside dans le fait que pour permettre la connexion de la puce 34 avec l'autre support 32, il est ensuite généralement nécessaire de réaliser d'autres plots conducteurs 36 en face arrière de la puce 34 situés à une extrémité des éléments d'interconnexion 35. Pour cela des étapes supplémentaires de dépôt d'une couche conductrice en face arrière de la puce 34 et de formation de motifs dans cette couche sont effectuées.

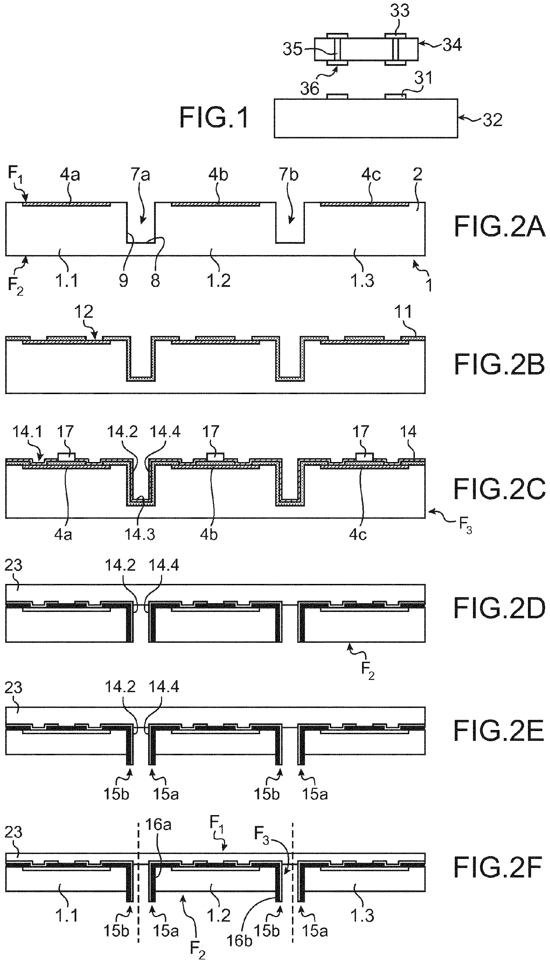

La figure 1 représente un assemblage ultérieur entre des plots conducteurs 36 qui ont dû être réalisés en face arrière de la puce 34 et les plots 31 de l'autre support 32.

Le document US 2004/0157410A1 et le document WO 2011/126726 A1 présentent un procédé de réalisation d'éléments de connexion dans lequel on :
- forme une couche conductrice sur un support doté de plots conducteurs disposés en face avant du support,
- amincir le support au niveau de sa face arrière de sorte à libérer du support une extrémité conductrice, cette extrémité conductrice libre dépassant de la face arrière du support.

Il se pose le problème de trouver un nouveau procédé d'interconnexion amélioré vis-vis d'inconvénients donnés ci-dessus.

### EXPOSÉ DE L'INVENTION

Selon un mode de réalisation, la présente invention prévoit un procédé selon la revendication 1 comprenant en outre un procédé de réalisation d'un ou plusieurs éléments de connexion dépassant de la face arrière d'un support, les éléments de connexion étant connectés respectivement à un ou plusieurs plots conducteurs disposés en face avant du support, le procédé comprenant des étapes de :
a) formation d'une couche conductrice sur le support, la couche conductrice étant agencée de sorte qu'elle comporte une première portion conductrice en contact avec au moins un plot conducteur disposé sur la face avant, la première portion conductrice s'étendant sur la face avant et étant reliée à au moins une deuxième portion conductrice s'étendant contre au moins une paroi donnée du support, la paroi donnée étant située entre la face avant et la face arrière et réalisant un angle non-nul avec la face avant du support,
b) amincir le support au niveau de sa face arrière de sorte à libérer du support une extrémité de la deuxième portion conductrice,
c) au moins une étape de pliage d'une extrémité conductrice libre dépassant de la face arrière du support et libérée à l'étape b).

Cette extrémité conductrice libre dépasse de la face arrière du support et peut être amenée à établir une connexion entre un plot conducteur situé sur la face avant et un autre plot ou un dispositif disposé(e) du côté de la face arrière.

Les plots conducteurs peuvent être disposés respectivement sur des parties actives de puces.

Selon une possibilité de mise en oeuvre, le procédé comprend préalablement à l'étape a) la réalisation d'une ou plusieurs tranchées à travers la face avant du support, les tranchées ayant un fond situé dans l'épaisseur du support.

Les tranchées sont alors recouvertes par la couche conductrice à l'étape a).

Un tel procédé permet de réaliser des éléments de connexion utilisant une surface utile du support moins importante que les éléments d'interconnexion TSV et de permettre de déporter ces éléments hors d'une zone utile.

La ou les tranchées peuvent réaliser une délimitation entre des circuits intégrés ou des puces électroniques ou des composants électroniques disposés dans le support.

Contrairement aux techniques communes de micro-câblage, le procédé peut permettre de réaliser des éléments de connexion collectivement à l'échelle d'un support ou d'une plaquette communément appelée « wafer » doté(e) de plusieurs circuits intégrés ou plusieurs puces électroniques ou plusieurs composants électroniques.

Ces éléments de connexion peuvent être réalisés de sorte à contourner une puce par ses bords latéraux et dépasser de la face arrière ou du dessous de cette puce afin éventuellement d'être recourbés ensuite le long de la face arrière ou du dessous de cette puce.

La couche conductrice peut être déposée de sorte à recouvrir le fond et sur les parois latérales d'une tranchée. Cela peut permettre de réaliser simultanément deux portions conductrices pour deux structures ou puces distinctes délimitées par cette tranchée.

Un mode de réalisation particulier prévoit de réaliser une tranchée débouchant au niveau de la face avant du support munie d'une paroi latérale réalisant un angle inférieur à 90° avec la face avant. Cela permet ensuite de former l'extrémité conductrice libre sur une paroi latérale inclinée, ce qui peut permettre par la suite de faciliter son pliage et/ou son assemblage avec une autre structure ou une autre puce.

Selon une possibilité de mise en oeuvre dans laquelle la couche conductrice est formée à l'étape a) de sorte qu'elle comporte une troisième portion conductrice reliée à la deuxième portion conductrice et une quatrième portion conductrice tapissant une autre paroi latérale de tranchée, la troisième portion conductrice tapissant le fond de la tranchée et reliant la deuxième portion conductrice et la quatrième portion conductrice, l'étape b) d'amincissement peut être effectuée de sorte à atteindre le fond de la tranchée et supprimer la troisième portion conductrice de manière à libérer une extrémité conductrice des deuxième et quatrième portion.

Dans ce cas, l'étape d'amincissement permet de séparer la troisième portion conductrice de la quatrième portion conductrice, ces portions pouvant être destinées à former des éléments de connexion distincts et susceptibles d'appartenir éventuellement à des puces ou des circuits ou des composants différents.

Préalablement à l'étape a) et au dépôt de la couche conductrice, les tranchées peuvent être revêtues d'une couche isolante permettant d'isoler électriquement le support de la couche conductrice. La couche isolante peut être en particulier formée sur une paroi latérale d'une tranchée destinée à former un bord latéral d'une puce.

Selon une possibilité de mise en oeuvre du procédé dans lequel le support comporte au moins une tranchée débouchant au niveau de sa face avant, le procédé peut comprendre en outre entre l'étape a) et l'étape b), la réalisation de motifs conducteurs dans la couche conductrice.

Une étape de retrait localisé de la couche conductrice peut être également effectuée de manière à définir des éléments conducteurs disjoints longeant la paroi latérale de la tranchée. Ce retrait localisé peut être effectué par exemple en effectuant un trou ou une saignée au niveau de la paroi latérale ou par exemple en effectuant une ablation laser d'une zone de la couche conductrice située sur la paroi latérale.

Selon une possibilité de mise en oeuvre, le procédé peut comprendre en outre entre l'étape a) et l'étape b), une étape de report d'un moyen de soutien mécanique, en face avant du support. Ce moyen de soutien peut permettre de maintenir solidaires entre elles différentes régions du support lors de l'étape d'amincissement et éviter une cassure de ce dernier. Le moyen de soutien peut-être par exemple un substrat poignée ou un couche de soutien.

Selon une possibilité de mise en oeuvre, dans laquelle le support comporte une première puce électronique et une deuxième puce électronique, une tranchée étant disposée entre la première puce et la deuxième puce, le procédé peut comprendre en outre, après l'étape b) : une étape de séparation de la première puce et de la deuxième puce.

Ainsi, on peut former un élément de connexion reliant électriquement la face avant et la face arrière du support sans avoir à réaliser un dépôt en face arrière du support.

L'extrémité conductrice une fois repliée peut être ensuite amenée à être connectée et assemblée à un autre dispositif, par exemple à une autre puce.

Le pliage de la ou des extrémités conductrices libérées à l'étape b) peut être réalisé après l'étape de séparation.

Ce pliage est avantageusement réalisé de sorte à ramener l'extrémité libre vers la face arrière de la puce, ce qui permet, une fois la puce assemblée et connectée à un autre dispositif de limiter l'encombrement du système formé par la puce et cet autre dispositif.

Le pliage de la ou des extrémités conductrices peut être réalisé au moins à l'aide d'un apport de chaleur.

Avantageusement, pour permettre de favoriser le pliage par apport de chaleur, on peut prévoir de former la couche conductrice par un empilement d'au moins un premier matériau et d'au moins un deuxième matériau en contact avec le premier matériau et ayant un coefficient de dilatation thermique supérieur à celui du premier matériau afin de créer un bilame. Par apport de chaleur, la dilatation du deuxième matériau étant supérieure à celle du premier matériau, l'extrémité conductrice se courbera en direction de la face arrière de la puce.

En variante ou en combinaison de l'apport de chaleur, le pliage peut être effectué à l'aide d'une mise en pression mécanique d'au moins une extrémité conductrice libre contre un flanc latéral incliné d'une cavité.

Avantageusement, on réalise un pliage par thermo-compression à l'aide d'un dispositif de préhension configuré pour chauffer la ou les extrémités conductrices libres tout en les appliquant contre un autre dispositif.

Selon une possibilité de mise en oeuvre du procédé dans lequel le support comporte au moins une tranchée débouchant au niveau de sa face avant, la tranchée délimitant une puce disposée dans le support, et dans lequel ladite paroi donnée est une paroi latérale de la tranchée, le procédé peut comprendre en outre, après l'étape b), des étapes de :
- séparation de la puce par découpe le long de la tranchée,
- assemblage de la puce sur un autre support doté d'au moins un plot conducteur, de sorte que ladite extrémité conductrice libre soit mise en contact avec le plot conducteur de l'autre support.

Lorsque la paroi latérale réalise un angle inférieur à 90° avec la face avant du support, l'étape ultérieure d'assemblage avec l'autre support est facilitée dans la mesure où l'extrémité libre est déjà orientée en direction de la face arrière de la puce.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 sert à illustrer une étape d'assemblage et de connexion entre une puce et un support suivant une technique de l'art antérieur ;
- les figures 2A-2F servent à illustrer, par le biais de vues en coupes transversales un procédé visant à former des éléments conducteurs reliés à la face avant d'un support et dotés d'une extrémité conductrice libre au niveau de la face arrière du support ;
- les figures 3A-3E servent à illustrer, par le biais de vues de dessus, un procédé suivant un mode de réalisation de la présente invention ;
- les figures 4A-4H servent à illustrer, par le biais d'une vues de trois-quarts, un procédé suivant un mode de réalisation de la présente invention ;
- les figures 5A-5B servent à illustrer un procédé de pliage de l'extrémité conductrice libre d'éléments conducteurs ;
- les figures 6A-6B servent à illustrer, après leur pliage, un assemblage de l'extrémité conductrice des éléments conducteurs dépassant de la face arrière d'un support avec un autre dispositif ;
- les figures 7A-7D servent à illustrer une variante de réalisation pour laquelle un dispositif de préhension d'une puce ou d'un support est configuré pour chauffer les éléments conducteurs sur cette puce ou ce support de sorte à les recourber et les mettre ensuite en pression contre un autre dispositif;
- la figure 8 illustre une variante de réalisation du procédé suivant l'invention pour laquelle le dispositif de départ est un support reconstitué ;
- la figure 9 sert à illustrer une variante de réalisation du procédé suivant l'invention dans laquelle on forme des trous longeant les parois latérales de tranchées afin de réaliser une séparation des zones conductrices formées sur ces parois ;
- Les figures 10A-10B servent à illustrer une variante de réalisation du procédé suivant l'invention dans laquelle des éléments de connexion passant par les bords latéraux d'une puce sont formés directement sur la puce préalablement à son amincissement ;
- Les figures 11 et 12 servent à illustrer des assemblages de puces à bords latéraux réalisant un angle aigu par rapport à leur face avant, la connexion entre une première puce et une deuxième puce sous-jacente étant réalisée par le biais d'éléments de connexion longeant les bords latéraux de la première puce ;
- Les figures 13A-13E servent à illustrer un procédé de réalisation d'une puce à bords latéraux réalisant un angle aigu avec sa face avant et dotée d'éléments conducteurs s'étendant sur ses bords latéraux ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation, telle que « latérale », « avant », « arrière », « dessous », etc. d'une structure s'appliquent en considérant que la structure est orientée de la façon illustrée sur les figures.

### EXPOSÉ DÉTAILLÉ DE MODES DE RÉALISATION PARTICULIERS

Un exemple de procédé suivant un mode de réalisation de la présente invention, pour mettre en oeuvre un dispositif comportant un ou plusieurs éléments de connexion dépassant en face arrière d'un support et connectés respectivement à un ou plusieurs plots conducteurs disposés en face avant de ce support va à présent être décrit en liaison avec les figures 2A-2F, 3A-3E, 4A-4H donnant respectivement des vues en coupe transversale, des vues de dessus, et des vues de trois-quarts du dispositif en cours de réalisation.

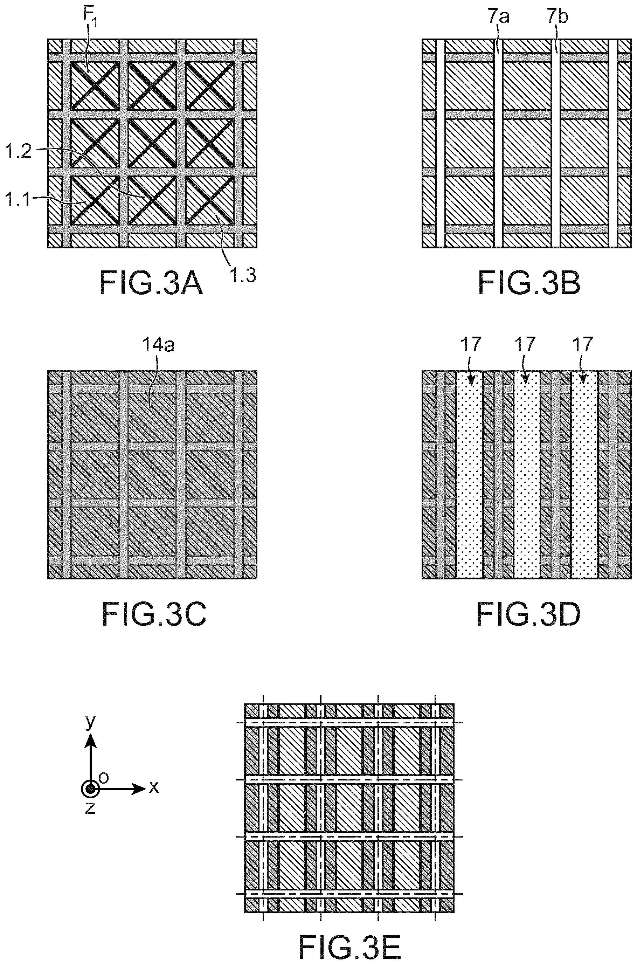

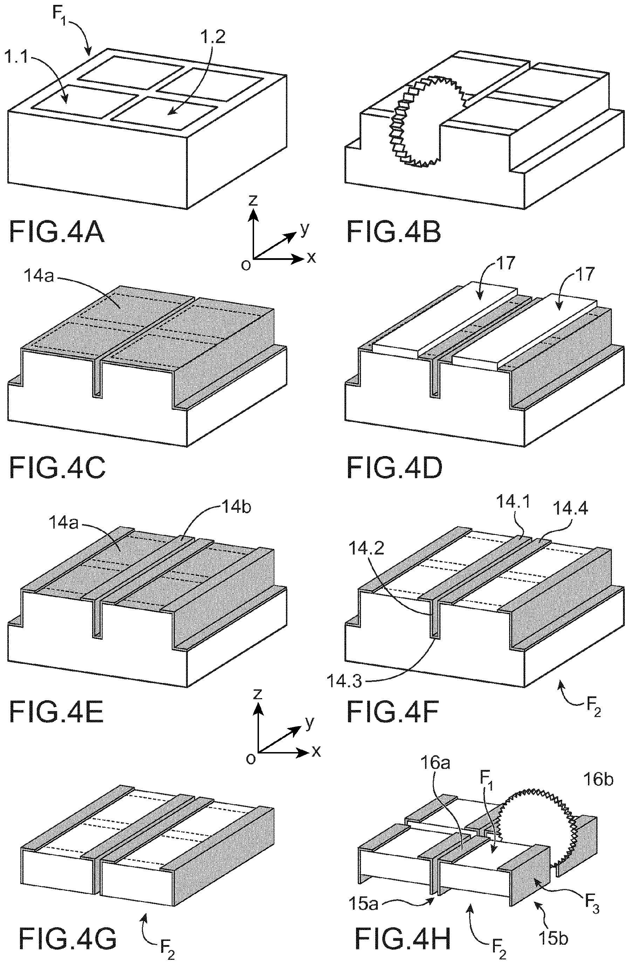

On se réfère tout d'abord aux figures 3A et 4A qui illustrent un dispositif de départ possible du procédé sous forme d'un support 1, formé d'une plaque 2 ou d'un substrat 2, par exemple à base de matériau semi-conducteur. Le support 1 peut comprendre des éléments 1.1, 1.2, 1.3 destinés à être séparés les uns des autres, tels que par exemple des puces électroniques ou des circuits intégrés ou des composants électroniques, identiques ou non entre eux.

Comme cela est illustré sur la figure 2A, le support 1 peut être également doté sur une de ses faces que l'on appelle « face avant » F1 d'une ou plusieurs, parties active des puces, dotées respectivement de plots conducteurs disjoints 4a, 4b, 4c.

Une ou plusieurs tranchées 7a, 7b sont tout d'abord réalisées à travers la face avant du support 1 (figures 2A et 3B). Les tranchées 7a, 7b délimitent les éléments 1.1, 1.2, 1.3 du support destinés à être séparés les uns des autres. Selon un exemple de réalisation illustré sur la figure 4B, les tranchées 7a, 7b peuvent être formées par sciage.

Les tranchées 7a, 7b sont réalisées de préférence de sorte qu'elles ne traversent pas toute l'épaisseur du support 1. Par « épaisseur » on entend ici une dimension mesurée, entre la face avant F1 et une face dite « face arrière » F2 opposée à la face avant, dans une direction parallèle au vecteur z d'un repère orthogonal [O;x;y;z].

Les tranchées 7a, 7b comportent ainsi un fond 8 situé dans l'épaisseur du support 1 et des parois latérales 9 qui s'étendent dans une direction réalisant un angle non-nul avec la face avant et/ou la face arrière du support. Dans l'exemple particulier de la figure 2A, les parois latérales 9 des tranchées 7a, 7b s'étendent dans une direction orthogonale aux faces avant F1 et arrière F2 du support 1. L'angle que réalisent les parois latérales 9 avec la face avant F1 ou la face arrière F2 peut être toutefois différent de 90°.

On forme ensuite une couche isolante 11 sur la face avant F1 du support 1. Dans l'exemple particulier illustré sur la figure 2B, la couche isolante 11 réalisée est répartie de sorte à recouvrir le fond 8 et les parois latérales 9 des tranchées 7a, 7b.

Certaines régions des plots conducteurs 4a, 4b, 4c peuvent être également revêtues. La couche isolante 11 comporte des ouvertures 12 dévoilant d'autres régions des parties actives des puces, et en particulier des plots conducteurs 4a, 4b, 4c.

Pour réaliser une telle couche isolante 11 discontinue, des étapes de dépôt et de photolithographie peuvent être par exemple mises en oeuvre. La couche isolante 11 peut être par exemple à base d'un matériau diélectrique minéral ou d'un polymère pour lui conférer une plus grande souplesse.

On forme ensuite une couche conductrice 14 en face avant F1 du support 1. La couche conductrice 14 réalisée peut être discontinue et formée de zones conductrices distinctes, c'est à dire qui sont disjointes et ne sont pas connectées entre elles.

Pour réaliser cette couche conductrice 14, une méthode possible comprend le dépôt préalable d'une couche 14a de germination par exemple à base de Ti et de Cu sur la face avant F1 du support 1 (figures 3C et 4C). Ce dépôt peut être réalisé par exemple par PVD (pour « Physical Vapor Déposition »).

Ensuite, des éléments 17 de masquage, par exemple à base de résine photosensible, sont formés, par exemple par photolithographie, sur des zones de la couche 14a de germination situées respectivement en regard des parties actives des puces (figures 3D, 4D).

Puis, une couche métallique 14b, par exemple à base de cuivre, est formée par métallisation de régions dévoilées de la couche 14a de germination qui ne sont pas protégées par les éléments 17 de masquage (figure 2C).

On retire ensuite les éléments 17 de masquage (figure 4E), puis on grave des zones de la couche 14a de germination qui ne sont pas recouvertes par la couche métallique 14b (figure 4F). Des motifs peuvent être réalisés dans la couche conductrice 14, par exemple par gravure ou ablation laser.

La couche conductrice 14 ainsi réalisée comporte une portion conductrice 14.1 en contact avec un plot conducteur 4a disposé sur la face avant du support, la portion conductrice 14.1 s'étendant sur la face avant et étant reliée à une autre portion conductrice 14.2 qui s'étend sur une paroi réalisant un angle non-nul avec la face avant.

Dans l'exemple de réalisation de la figure 2C, l'autre portion conductrice 14.2 s'étend le long d'une paroi latérale 9 de tranchée 7a et peut être reliée à une portion conductrice 14.3 tapissant le fond 8 de la tranchée 7a, elle-même reliée à une portion conductrice 14.4 disposée le long d'une autre paroi latérale 9 de la tranchée 7a.

Ainsi, sur l'exemple donné en figure 2C, la couche conductrice 14 réalisée est répartie de sorte à recouvrir le fond 8 et les parois latérales 9 des tranchées 7a, 7b, ainsi que lesdites autres régions des parties actives de puces et en particulier des plots conducteurs 4a, 4b, 4c dévoilées par les ouvertures 12 prévues dans la couche isolante 11.

D'autres agencements dans lesquels la couche conductrice 14 recouvre partiellement les tranchées 7a, 7b et/ou recouvre une paroi latérale F3 du support 1 peuvent être également prévus. On peut en variante, ne pas réaliser la portion conductrice 14.3 au fond de la tranchée en réalisant un dépôt sous incidence oblique.

On réalise ensuite un amincissement du support 1 au niveau de sa face arrière F2. Dans l'exemple de réalisation illustré sur les figures 2D et 4G, cet amincissement est réalisé de sorte à atteindre le fond 8 des tranchées 7a, 7b.

Dans ce cas, une portion 14.3 de la couche conductrice 14 située au fond des tranchées peut être supprimée. On sépare alors entre elles des portions conductrices 14.2 et 14.4 de la couche conductrice situées sur des parois latérales des tranchées.

Comme cela est illustré sur l'exemple de réalisation particulier de la figure 2D, une couche 23 dite « de soutien mécanique » rapportée préalablement à l'amincissement peut être prévue en face avant F1 du support 1 afin d'aider au maintien solidaire des éléments 1.1, 1.2, 1.3 du support 1 entre eux et/ou d'empêcher une casse du support 1 lors de l'amincissement. En variante, un substrat poignée peut être prévu pour réaliser le soutien mécanique.

Un exemple de méthode pour réaliser cet amincissement comprend une étape de meulage (« grinding » selon la terminologie anglo-saxonne) du support.

L'amincissement peut être ensuite prolongé comme cela est illustré sur la figure 2E, de sorte à libérer des extrémités 15a, 15b de portions conductrices 14.2, 14.4 formées sur des parois latérales des tranchées. Ces extrémités conductrices 15a, 15b libres dépassent de la face arrière F2 du support 1 et ne sont pas en contact avec ce dernier. Ce retrait supplémentaire d'une portion du support 1 au niveau de sa face arrière F2 peut être réalisé par exemple par gravure. Dans le cas où le support 1 est à base de silicium, une gravure à l'aide de plasma fluoré peut être par exemple mise en oeuvre.

Les extrémités 15a, 15b conductrices ainsi libérées peuvent être destinées ensuite à être connectées à des zones conductrices d'un autre support.

Après l'amincissement du support 1 par sa face arrière et la libération des extrémités 15a, 15b de portions conductrices, on peut réaliser une séparation des puces ou circuits intégrés ou composants 1.1, 1.2, 1.3 du support 1.

La séparation peut comprendre le retrait de la couche 23 soutien. Ce retrait peut être réalisé notamment par une action mécanique par exemple en pelant cette couche 23.

Une découpe supplémentaire du support 1 peut être ensuite effectuée pour permettre de séparer les puces 1.1, 1.2, 1.3 entre elles. Cette découpe peut être effectuée selon des plans de découpe qui traversent les tranchées 7a et 7b et s'étendent orthogonalement aux tranchées 7a, 7b.

Sur les figures 2F et 3E les plans de découpe sont représentés par le biais de traits discontinus.

Un exemple de réalisation illustré sur la figure 4H, prévoit de réaliser cette séparation par sciage.

Au final, on obtient des puces 1.1, 1.2, 1.3 dotés d'éléments 16a, 16b de connexion distincts disposés en face avant F1 des puces et qui s'étendent de part et d'autre des puces le long de leurs parois latérales F3 ou bordures latérales F3. Les éléments 16a, 16b de connexion comportent des extrémités 15a, 15b dépassant au-delà de la face arrière F2 et qui sont amenées à être connectées avec un autre dispositif ou un autre support.

Un exemple de procédé tel que décrit précédemment s'adapte tout particulièrement à la réalisation d'éléments de connexion sur un support 1 ou des puces 1.1, 1.2, 1.3 de faible épaisseur par exemple comprise entre 50 et 200 µm.

Une variante du procédé qui vient d'être décrit prévoit d'utiliser comme dispositif de départ un support reconstitué tel que décrit par exemple dans le document WO 2008/155231 et comprenant une plaquette 80 ou une plaque à base de silicium de verre ou de polymère dotée de cavités 82 dans lesquelles des puces 1.1, 1.2, 1.3 ou des composants ou des circuits intégrés sont logé(e)s et sont rattaché(e)s à la plaquette au moyen d'un adhésif 84.

Dans l'exemple de réalisation illustré sur la figure 4H, les éléments 16a, 16b de connexion formés sur les puces 1.1, 1.2, 1.3 s'étendent sur toute la longueur L (mesurée parallèlement à l'axe y du repère [O;x;y;z]) de leurs bords ou flancs latéraux.

En variante, pour réaliser des éléments de connexion 16a ou 16b qui s'étendent sur une portion seulement des bords latéraux d'une puce 1.2 ou 1.3, on peut après métallisation des tranchées et préalablement à l'étape de séparation des puces 1.2, 1.3, former des trous 91 dans les parois latérales des tranchées.

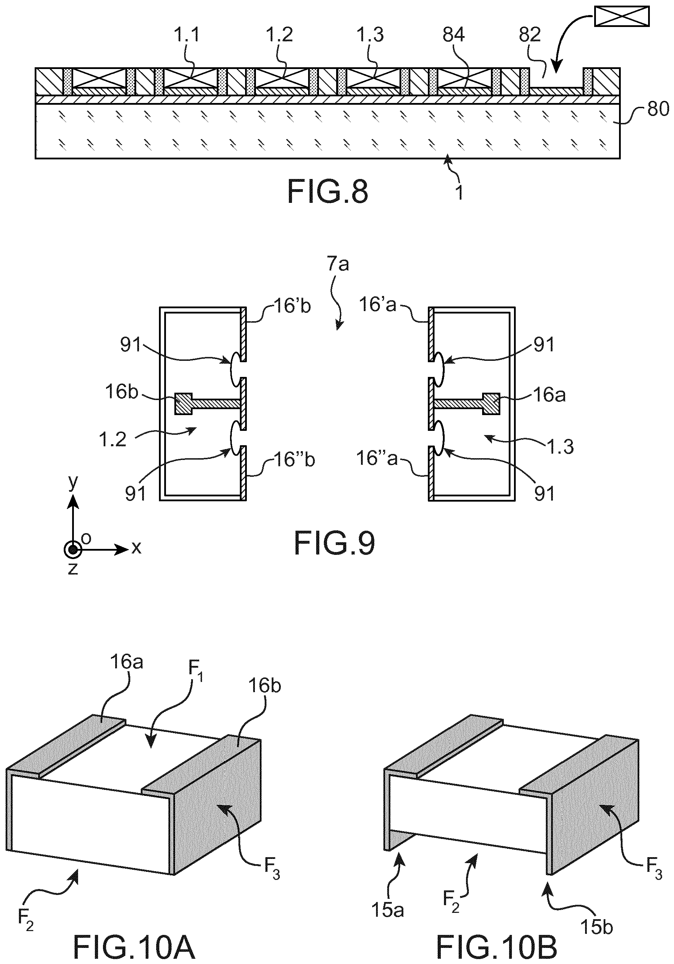

Une telle variante est illustrée sur la figure 9 donnant une vue de dessus d'une tranchée 7b séparant les bords latéraux de deux puces 1.2 et 1.3. Plusieurs éléments de connexion 16a, 16'a, 16"a ou 16b, 16'b, 16"b disjoints et qui ne sont pas connectés entre eux peuvent être ainsi réalisés sur les bords latéraux de chaque puce.

Selon un autre exemple de réalisation, pour définir des éléments de connexion 16a 16'a, 16"a indépendants et disjoints longeant une même paroi latérale d'une tranchée, on peut par exemple effectuer une ablation laser.

Pour permettre de réaliser un assemblage et une connexion d'une puce 1.1 avec un autre support une fois le découpage du support réalisé, un pliage des extrémités conductrices 15a, 15b libres des éléments de connexion 16a, 16b est prévu.

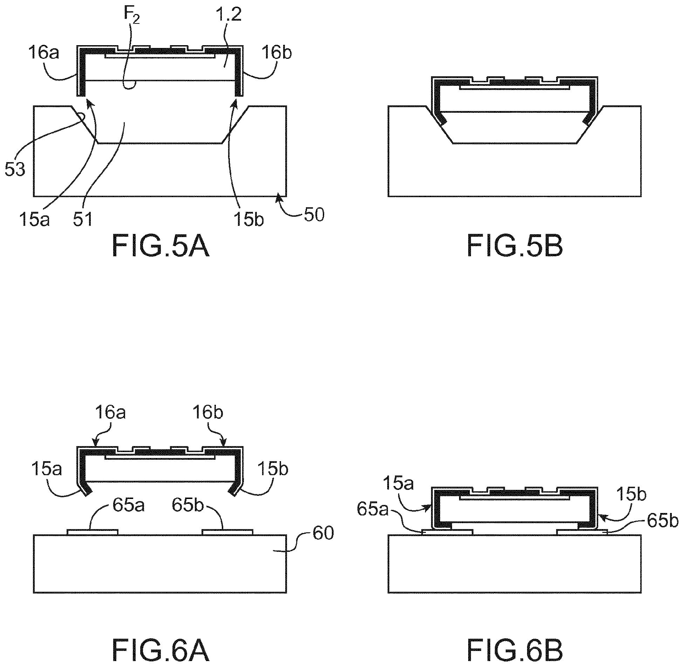

Un exemple de méthode de pliage des extrémités conductrices 15a, 15b libres dépassant de la face arrière d'une puce 1.2 ou d'un circuit intégré 1.2 une fois le support 1 découpé est illustré sur les figures 5A-5B.

Dans cet exemple, on effectue ce pliage de sorte à ramener les extrémités conductrices 15a, 15b d'éléments 16a, 16b de connexion en direction de la face arrière F2 de la puce 1.2. Pour cela, on met ces extrémités conductrices libres 15a, 15b en pression contre des flancs latéraux inclinés 53 d'une cavité 51 prévue dans un support 50. Ce support 50 sert alors de presse contre laquelle la puce 1.2 est mise en appui.

La préhension de la puce 1.2 et sa mise en appui contre le support 50 peut être réalisée à l'aide d'un appareil robotisé par exemple de type communément appelé « pick and place ».

Une fois les extrémités conductrices 15a, 15b recourbées sous la puce 1.2, on peut ensuite effectuer un assemblage de cette puce 1.2 avec un autre dispositif, tel qu'un support PCB (de l'anglais « Printed circuit board ») ou une carte électronique ou un interposeur de circuit intégré ou une autre puce identique ou non.

Les figures 6A-6B illustrent un exemple d'un tel type d'assemblage dans lequel les extrémités conductrices libres 15a, 15b partiellement recourbées vers la face arrière F2 de la puce, sont ensuite mises en appui contre des zones conductrices 65a, 65b d'un substrat d'interconnexion 60. On met ainsi en contact électrique des éléments de connexion 16a, 16b de la puce 1.2 avec les zones conductrices 65a, 65b du substrat 60, et on met en contact mécanique les extrémités conductrices 15a, 15b avec la face arrière de la puce 1.2.

On obtient ainsi un assemblage et une connexion entre le substrat 60 et la puce 1.2 d'encombrement réduit.

En variante ou en combinaison d'une action mécanique, le pliage des extrémités conductrices 15a, 15b peut être réalisé à l'aide d'un apport de chaleur.

Dans ce cas, les extrémités conductrices 15a, 15b peuvent être avantageusement formées d'un empilement de matériaux conducteurs en contact l'un de l'autre et ayant des coefficients de dilatation thermique respectifs différents.

Un empilement de Ti et de Cu peut être par exemple réalisé pour former la couche conductrice 14 à base de laquelle les extrémités conductrices 15a, 15b sont formées, dans la mesure où le rapport entre les coefficients de dilatation thermique de ces matériaux est de l'ordre de 2.

En mettant en oeuvre une couche conductrice 14 formée d'un bicouche ayant les propriétés d'un bilame, un effet de recourbement partiel des extrémités conductrices 15a, 15b libres peut être obtenu lorsqu'on réalise un apport de chaleur suffisant. Par exemple pour un bilame Ti/Cu on se place de préférence à une température supérieure à 100°C et par exemple de l'ordre de 200°C ou plus.

Pour permettre également de favoriser le pliage des extrémités conductrices 15a, 15b, on peut également adapter le procédé de réalisation de la couche conductrice 14, en particulier lorsque la couche conductrice 14 est formée d'un empilement de matériaux différents.

Les différentes méthodes évoquées plus haut permettant de favoriser le pliage peuvent être combinées.

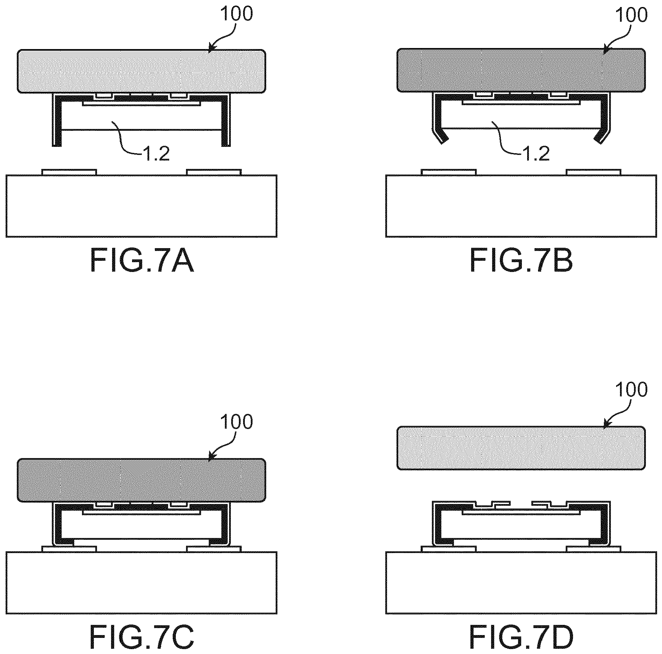

Les figures 7A-7D illustrent un exemple d'assemblage entre la puce 1.2 et un support 60 à l'aide d'un dispositif 100 configuré pour prendre la puce 1.2 (figure 7A), puis chauffer la puce 1.2 de sorte à provoquer un recourbement des extrémités conductrices 15a, 15b (figure 7B), mettre en pression la puce 1.2 contre des zones conductrices 65a, 65b du substrat 60 tout en maintenant l'apport de chaleur (figure 7C).

En fonction de la nature des matériaux que l'on souhaite assembler, une brasure peut être mise en oeuvre. Une fois que l'assemblage et la connexion entre la puce 1.2 et le substrat 60 sont réalisés, le dispositif 100 relâche la puce (figure 7D).

Le dispositif 100 utilisé peut être par exemple un robot de type « pick and place » doté de moyens de préhension chauffants.

Les figures 10A, 10B illustrent une autre variante de réalisation dans laquelle les éléments 16a, 16b de connexion sont formées sur une puce 1.2 individuelle déjà découpée. Les éléments de connexion 16a, 16b disposés en face avant de la puce s'étendent de part et d'autre de la puce le long des bords latéraux ou parois latérales F3 de la puce (figure 10A). On effectue ensuite un amincissement de la puce 1.2 par sa face arrière F2, de sorte à libérer de la puce 1.2 les extrémités des éléments de connexion 16a, 16b (figure 10B).

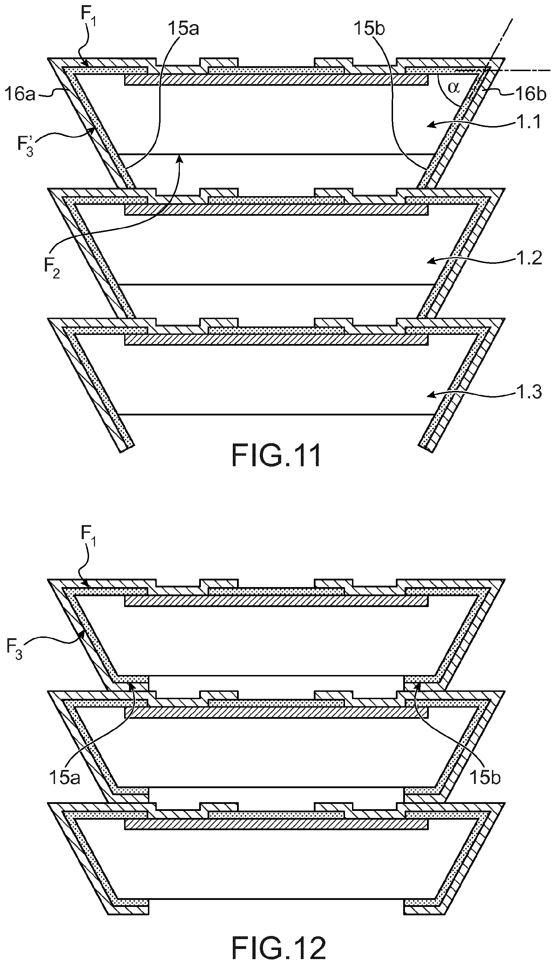

Sur la figure 11, une superposition de puces 1.1, 1.2, 1.3 a été réalisée chacune des puces 1.1, 1.2, 1.3 étant dotée d'éléments de connexion 16a, 16b disposés en face avant et qui s'étendent de part et d'autre de la puce le long des bords latéraux ou parois latérales F'₃ de la puce. Dans cet exemple de réalisation particulier, les bords latéraux ou parois latérales F'₃ des puces 1.1, 1.2, 1.3 réalisent un angle α inférieur à 90°, par exemple compris entre 75° et 85° avec leur face avant F₁. Les puces 1.1, 1.2, 1.3 peuvent avoir en particulier une section transversale sensiblement de la forme d'un trapèze dont la plus grande des bases correspond à la face avant F₁ de la puce et dont la plus petite des bases correspond à la face arrière F₂ de la puce.

Le fait de prévoir un angle α aigu entre un bord latéral F₃ d'une puce 1.1 et sa face avant F₁ permet de faciliter la connexion entre un élément de connexion 16a, 16b qui s'étend sur sa face avant F₁ et sur un bord latéral F₃ et une zone conductrice d'un autre dispositif, que l'on place en regard de la face arrière F₂ de la puce 1.1

Dans l'exemple de réalisation particulier de la figure 11, des extrémités 15a, 15b libres des éléments de connexion 16a, 16b d'une puce 1.1 sont ainsi connectés à d'autres éléments de connexion 16a, 16b d'une autre puce 1.2 au niveau de la face avant de cette autre puce 1.2. Les extrémités 15a, 15b libres des éléments de connexion 16a, 16b d'une puce 1.1 sont ici connectées sans nécessairement devoir être repliées vers la face arrière F₂ de cette puce 1.1

Sur la figure 12, un assemblage plus compact est illustré, avec cette fois les extrémités 15a, 15b des éléments de connexion 16a, 16b d'une puce 1.1 qui sont repliées et s'étendent le long d'une portion de la face arrière F₂ de cette puce 1.1.

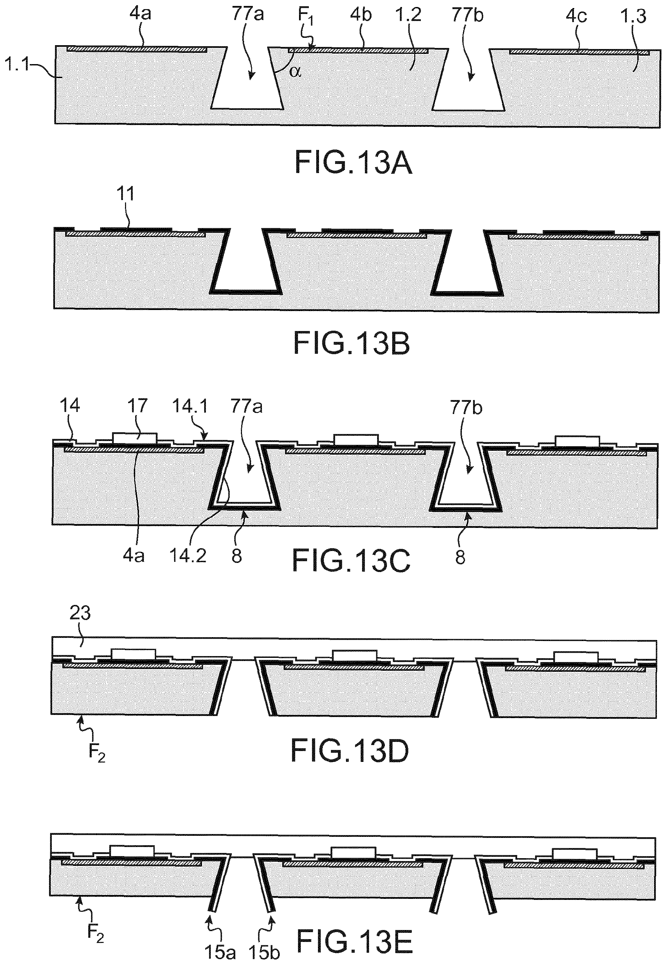

Un exemple de procédé pour réaliser des puces 1.1, 1.2, 1.3 à bords latéraux inclinés tels qu'illustrés sur les figures 11 ou 12, va à présent être donné en liaison avec les figures 13A-13E.

On peut démarrer le procédé à partir d'un même dispositif de départ que dans l'exemple de procédé décrit précédemment en liaison avec les figures 2A-2F.

Une ou plusieurs tranchées 77a, 77b sont tout d'abord réalisées à travers la face avant F1 du support 1 (figure 13A). Dans cet exemple, les tranchées 77a, 77b comportent un fond 8 situé dans l'épaisseur du support 1 et des parois latérales 9 qui s'étendent dans une direction réalisant un angle α inférieur à 90° avec la face avant F₁ du support. Les tranchées 77a, 77b ont ainsi un fond 8 plus large que leur embouchure. Les tranchées 77a, 77b délimitent des zones de séparation entre les puces 1.1, 1.2, 1.3.

Lorsque le support 1 est semi-conducteur et par exemple à base de silicium, les tranchées 77a, 77b peuvent être réalisées par exemple à l'aide d'un procédé du type de celui décrit dans le document US 5 501 893 ou dans le document « High aspect ratio Bosch etching of sub 0.25 µm trenches for hyperintegration » de Wang et al., Journal of Vacuum Science and Technology B 25, 1376 (2007).

On forme ensuite la couche isolante 11 sur certaines zones de la face avant F1 du support 1. La couche isolante 11 recouvre dans cet exemple le fond 8 et les parois latérales 79 des tranchées 77a, 77b (figure 13B).

On forme ensuite une couche conductrice 14 sur certaines régions de la face avant F₁ du support 1 qui ne sont pas recouvertes d'éléments de masquage 17 que l'on a formé au préalable par exemple par photolithographie. La couche conductrice 14 tapisse dans cet exemple le fond 8 et les parois latérales 79 des tranchées 77a, 77b (figure 13C).

La couche conductrice 14 ainsi réalisée comporte une portion conductrice 14.1 en contact avec un plot conducteur 4a disposé sur la face avant du support, la portion conductrice 14.1 s'étendant sur la face avant et étant reliée à une autre portion conductrice 14.2 qui s'étend sur une paroi réalisant un angle aigu α avec la face avant F1.

On réalise ensuite un amincissement du support 1 au niveau de sa face arrière F2. Dans l'exemple de réalisation illustré sur les figures 13C et 13D cet amincissement est réalisé de sorte à atteindre et supprimer le fond 8 des tranchées 77a, 77b.

Un moyen de soutien mécanique, par exemple sous forme d'un substrat poignée ou d'une couche 23 déposée peut être formé en face avant F1 du support 1 préalablement à l'amincissement, afin de pouvoir réaliser cette étape sans abimer le support 1.

L'étape d'amincissement peut être ensuite prolongée ou comprendre en outre comme cela est illustré sur la figure 13E, une gravure effectuée de sorte à libérer des extrémités 15a, 15b de portions conductrices formées sur des parois latérales des tranchées 77a, 77b. Ces extrémités conductrices 15a, 15b libres dépassent de la face arrière F2 du support 1 et ne sont pas en contact avec ce dernier. Les extrémités 15a, 15b conductrices ainsi libérées peuvent être destinées ensuite à être connectées à des zones conductrices d'un autre support, par exemple un substrat ou une autre puce.

Préalablement à un assemblage avec un autre support, on peut réaliser une découpe du support, de sorte à dissocier les puces 1.1, 1.2, 1.3. Cette découpe est avantageusement réalisée le long des tranchées 77a, une paroi latérale d'une tranchée formant alors un bord latéral d'une puce.

## Revendications

1. Procédé de réalisation d'un ou plusieurs éléments de connexion pour un dispositif microélectronique, comprenant des étapes consistant à :
a) former une couche conductrice (14) sur un support (1) formé d'une plaque ou d'un substrat, le support étant doté d'un ou plusieurs plots conducteurs (4a, 4b, 4c) disposés en face avant (F1) du support opposée à une face arrière (F2), la couche conductrice étant agencée de sorte qu'elle comporte une première portion conductrice (14.1) en contact avec au moins un plot conducteur (4a) disposé sur la face avant (F1), la première portion conductrice (14.1) s'étendant sur la face avant et étant reliée à au moins une deuxième portion conductrice (14.2) s'étendant contre au moins une paroi donnée (9) du support, la paroi donnée (9) étant située entre la face avant (F1) et la face arrière (F2) et réalisant un angle non-nul avec la face avant (F1) du support,
b) amincir le support au niveau de sa face arrière (F2) de sorte à libérer du support une extrémité conductrice (15a) de la deuxième portion conductrice (14.2), cette extrémité conductrice libre dépassant de la face arrière (F2) du support,
le procédé comprenant en outre après l'étape b) : c) au moins une étape de pliage d'une extrémité conductrice libre (15a, 15b) dépassant de la face arrière du support et libérée à l'étape b).

2. Procédé selon la revendication 1, dans lequel le support (1) comporte au moins une tranchée (7a, 7b, 77a, 77b) débouchant au niveau de sa face avant (F1), la paroi donnée (9) étant une paroi latérale de la tranchée.

3. Procédé selon la revendication 2, dans lequel la tranchée (7a, 7b, 77a, 77b) comporte un fond (8) situé entre la face avant (F1) et la face arrière (F2) du support (1), l'étape b) d'amincissement étant effectuée de sorte à atteindre le fond (8) de la tranchée puis à libérer l'extrémité (15b) de la deuxième portion conductrice cette extrémité conductrice libre dépassant de la face arrière (F2) du support (1).

4. Procédé selon l'une des revendications 1 à 3, dans lequel le support (1) comporte au moins une tranchée (7a, 7b, 77a, 77b) débouchant au niveau de sa face avant (F1), la paroi donnée (9) étant une paroi latérale de la tranchée, la couche conductrice (14) étant déposée dans le fond et sur des parois latérales de la tranchée.

5. Procédé selon l'une des revendications 1 à 4, dans lequel la paroi donnée (9) est revêtue préalablement à l'étape a) d'une couche isolante (11).

6. Procédé selon l'une des revendications 1 à 5, dans lequel le support (1) comporte au moins une tranchée (77a, 77b) débouchant au niveau de sa face avant (F1), la paroi donnée (9) étant une paroi latérale de la tranchée (77a, 77b), la paroi latérale réalisant un angle inférieur à 90° avec la face avant (F1).

7. Procédé selon l'une des revendications 1 à 6, le procédé comprenant en outre entre l'étape a) et l'étape b), une étape de report d'un substrat de soutien (23) ou d'une couche de soutien (23) en face avant du support (1).

8. Procédé selon l'une des revendications 1 à 7, dans lequel le support (1) comporte au moins une tranchée (7a, 7b) débouchant au niveau de sa face avant (F1) et dans lequel le support (1) comporte une première puce électronique (1.1) et une deuxième puce électronique (1.2), la tranchée (7a, 7b) étant disposée entre la première puce (1.1) et la deuxième puce (1.2), le procédé comprenant en outre, entre l'étape b) et l'étape c) :
une étape de séparation de la première puce (1.1) et de la deuxième puce (1.2).

9. Procédé selon l'une des revendications 1 à 8, dans lequel le support (1) comporte au moins une tranchée (7a, 7b) débouchant au niveau de sa face avant (F1) le procédé comprenant en outre entre l'étape a) et l'étape b), la réalisation de motifs conducteurs (16a, 16b) dans la couche conductrice.

10. Procédé selon la revendication 9, comprenant une étape de retrait localisé de la couche conductrice (14) de manière à définir des éléments conducteurs disjoints longeant la paroi latérale de la tranchée.

11. Procédé selon l'une des revendications 1 à 10, dans lequel le pliage de l'extrémité conductrice libre est réalisé de sorte à ramener l'extrémité libre vers la face arrière.

12. Procédé selon l'une des revendications 1 à 11, le pliage étant réalisé au moins à l'aide d'un apport de chaleur.

13. Procédé selon la revendication 12, dans lequel la couche conductrice (14) est formée d'un empilement d'au moins un premier matériau et d'au moins un deuxième matériau en contact avec le premier matériau et ayant un coefficient de dilatation thermique supérieur à celui du premier matériau.

14. Procédé selon l'une des revendications 1 à 13, dans lequel le pliage :
- comprend une mise en pression mécanique d'au moins une extrémité conductrice libre contre un flanc latéral incliné d'une cavité (53) contre lequel le support (1) est mis en appui, et/ou
- est réalisé à l'aide d'un dispositif de préhension configuré pour chauffer le support (1) tout en l'appliquant contre un autre support (60).

15. Procédé selon l'une des revendications 1 à 14, dans lequel le support (1) comporte au moins une tranchée (7a, 7b) débouchant au niveau de sa face avant (F1), la tranchée délimitant une puce (1.1) disposée dans le support, la paroi donnée (9) étant une paroi latérale de la tranchée, le procédé comprenant en outre, après l'étape b), des étapes de :
- séparation de la puce par découpe le long de la tranchée,
- assemblage de la puce (1.1) sur une structure dotée d'au moins plot conducteur, de sorte que l'extrémité conductrice libre dépassant soit mise en contact avec le plot conducteur.

## Patentansprüche

1. Verfahren zum Herstellen von einem oder mehreren Verbindungselementen für eine mikroelektronische Vorrichtung, umfassend die Schritte, bestehend aus:
a) Bilden einer leitfähigen Schicht (14) auf einem Träger (1), welcher aus einer Platte oder einem Substrat gebildet ist, wobei der Träger mit einem oder mehreren Leitungskontakten (4a, 4b, 4c) dotiert wird, welche an einer vorderen Fläche (F1) des Trägers gegenüber einer hinteren Fläche (F2) angeordnet werden, wobei die leitfähige Schicht derart eingerichtet wird, dass sie einen ersten leitfähigen Abschnitt (14.1) in Kontakt mit wenigstens einem an der vorderen Fläche (F1) angeordneten Leitungskontakt (4a) umfasst, wobei sich der erste leitfähige Abschnitt (14.1) an der vorderen Fläche erstreckt und mit wenigstens einem zweiten leitfähigen Abschnitt (14.2) verbunden wird, welcher sich gegen wenigstens eine vorgegebene Wand (9) des Trägers erstreckt, wobei die vorgegebene Wand (9) zwischen der vorderen Fläche (F1) und der hinteren Fläche (F2) platziert ist und einen Winkel mit der vorderen Fläche (F1) des Trägers bildet, welcher ungleich Null ist,
b) Verdünnen des Trägers auf dem Niveau seiner hinteren Fläche (F2) derart, dass von dem Träger ein leitfähiges Ende (15a) des zweiten leitfähigen Abschnitts (14.2) freigelegt wird, wobei dieses leitfähige Ende von der hinteren Fläche (F2) des Trägers vorsteht,
wobei das Verfahren nach dem Schritt b) ferner umfasst:
c) wenigstens einen Schritt eines Faltens eines freien leitfähigen Endes (15a, 15b), welches von der hinteren Fläche des Trägers vorsteht und in Schritt b) freigelegt worden ist.

2. Verfahren nach Anspruch 1, wobei der Träger (1) wenigstens eine Nut (7a, 7b, 77a, 77b) umfasst, welche auf dem Niveau seiner vorderen Fläche (F1) mündet, wobei die vorgegebene Wand (9) eine laterale Wand der Nut ist.

3. Verfahren nach Anspruch 2, wobei die Nut (7a, 7b, 77a, 77b) einen Boden (8) umfasst, welcher zwischen der vorderen Fläche (F1) und der hinteren Fläche (F2) des Trägers (1) angeordnet ist, wobei der Schritt b) des Verdünnens derart durchgeführt wird, dass der Boden (8) der Nut erreicht wird und dann das Ende (15b) des zweiten leitfähigen Abschnitts freigelegt wird, wobei dieses freie leitfähige Ende von der hinteren Fläche (F2) des Trägers (1) vorsteht.

4. Verfahren nach einem der Ansprüche 1 bis 3, wobei der Träger (1) wenigstens eine Nut (7a, 7b, 77a, 77b) umfasst, welche auf dem Niveau seiner vorderen Fläche (F1) mündet, wobei die vorgegebene Wand (9) eine laterale Wand der Nut ist, wobei die leitfähige Schicht (14) an dem Boden und an den lateralen Wänden der Nut angeordnet wird.

5. Verfahren nach einem der Ansprüche 1 bis 4, wobei die vorgegebene Wand (9) vor dem Schritt a) mit einer isolierenden Schicht (11) beschichtet wird.

6. Verfahren nach einem der Ansprüche 1 bis 5, wobei der Träger (1) wenigstens eine Nut (77a, 77b) umfasst, welche auf dem Niveau seiner vorderen Fläche (F1) mündet, wobei die vorgegebene Wand (9) eine laterale Wand der Nut (77a, 77b) ist, wobei die laterale Wand einen Winkel mit der vorderen Fläche (F1) bildet, welcher kleiner als 90° ist.

7. Verfahren nach einem der Ansprüche 1 bis 6, wobei das Verfahren ferner zwischen dem Schritt a) und dem Schritt b) einen Schritt eines Übertragens eines Stützsubstrats (23) oder einer Stützschicht (23) auf die vordere Fläche des Trägers (1) umfasst.

8. Verfahren nach einem der Ansprüche 1 bis 7, wobei der Träger (1) wenigstens eine Nut (7a, 7b) umfasst, welche auf dem Niveau seiner vorderen Fläche (F1) mündet, und wobei der Träger (1) einen ersten Elektronikchip (1.1) und einen zweiten Elektronikchip (1.2) umfasst, wobei die Nut (7a, 7b) zwischen dem ersten Chip (1.1) und dem zweiten Chip (1.2) angeordnet ist, wobei das Verfahren ferner zwischen dem Schritt b) und dem Schritt c) einen Schritt eines Separierens des ersten Chips (1.1) und des zweiten Chips (1.2) umfasst.

9. Verfahren nach einem der Ansprüche 1 bis 8, wobei der Träger (1) wenigstens eine Nut (7a, 7b) umfasst, welche auf dem Niveau seiner vorderen Fläche (F1) mündet, wobei das Verfahren ferner zwischen dem Schritt a) und dem Schritt b) das Bilden von leitfähigen Mustern (16a, 16b) in der leitfähigen Schicht umfasst.

10. Verfahren nach Anspruch 9, umfassend einen Schritt eines lokalisierten Entfernens der leitfähigen Schicht (14) derart, dass getrennte leitfähige Elemente entlang der lateralen Wand der Nut definiert werden.

11. Verfahren nach einem der Ansprüche 1 bis 10, wobei das Biegen des freien leitfähigen Endes derart durchgeführt wird, dass das freie Ende in Richtung der hinteren Fläche umgelenkt wird.

12. Verfahren nach einem der Ansprüche 1 bis 11, wobei das Biegen wenigstens mit Hilfe einer Wärmezufuhr durchgeführt wird.

13. Verfahren nach Anspruch 12, wobei die leitfähige Schicht (14) durch ein Stapeln von wenigstens einem ersten Material und wenigstens einem zweiten Material in Kontakt mit dem ersten Material und mit einem Wärmeausdehungs-Koeffizienten gebildet wird, welcher größer als derjenige des ersten Materials ist.

14. Verfahren nach einem der Ansprüche 1 bis 13, wobei das Falten:
- ein Setzen von wenigstens einem freien leitfähigen Ende unter mechanischen Druck gegen eine geneigte laterale Flanke eines Hohlraums (53) umfasst, gegen welchen der Träger (1) in Anlage versetzt wird, und/oder
- mittels einer Greifvorrichtung durchgeführt wird, welche dazu eingerichtet ist, den Träger (1) zu erwärmen, während er gegen einen anderen Träger (60) aufgelegt wird.

15. Verfahren nach einem der Ansprüche 1 bis 14, wobei der Träger (1) wenigstens eine Nut (7a, 7b) umfasst, welche auf dem Niveau seiner vorderen Fläche (F1) mündet, wobei die Nut einen Chip (1.1) begrenzt, welcher an dem Träger angeordnet ist, wobei die vorgegebene Wand (9) eine laterale Wand der Nut ist, das Verfahren ferner nach dem Schritt b) umfassend die Schritte:
- Separieren des Chips durch Schneiden entlang der Nut,
- Montieren des Chips (1.1) auf einer dotierten Struktur mit wenigstens einem Leitungskontakt derart, dass das vorstehende freie leitfähige Ende in Kontakt mit dem Leitungskontakt versetzt wird.

## Claims

1. A method of making one or several connection elements for a microelectronic device, comprising steps consisting of:
- forming a conducting layer (14) on a support (1) formed of a plate or a substrate, the support being provided with one or several conducting pads (4a, 4b, 4c) located on the front face (F1) of the support opposite the back face (F2), the conducting layer being arranged such that it comprises a first conducting portion (14.1) in contact with at least one conducting pad (4a) located on the front face, the first conducting portion (14.2) extending on the front face (9) and being connected to at least one second conducting portion extending in contact with at least one given wall of the support, the given wall (9) being located between the front face (F1) and the back face (F2) and making a non-zero angle with the front face (F1) of the support,
- thinning the support at its back face (F2) so as to release one conducting end (15a) of the second conducting portion (14.2), this free conducting portion, this free conducting end projecting from the back face (F2) of the support,
the method further including, after thinning of the support: bending of a free conducting end (15a, 15b) projecting from the back face of the support and released at the time of thinning.

2. The method according to claim 1, wherein the support (1) comprises at least one trench (7a, 7b, 77a, 77b) opening up at its front face (F1), the given wall (9) being a lateral wall of the trench.

3. The method according to claim 2, wherein the trench (7a, 7b, 77a, 77b) comprises a bottom (8) located between the front face (F1) and the back face (F2) of the support (1), thinning being done so as to reach the bottom (8) of the trench and then releasing the end (15b) of the second conducting portion, this free conducting end projecting from the back face (F2) of the support (1).

4. The method according to any of the claims 1 to 3, wherein the support (1) comprises at least one trench (7a, 7b, 77a, 77b) opening up on its front face (F1), the given wall (9) being a lateral wall of the trench, the conducting layer (14) being deposited in the bottom and on the lateral walls of the trench.

5. The method according to any of the claims 1 to 4, wherein the given wall (9) is coated with an insulating layer before formation of the conducting layer (11).

6. The method according to any of the claims 1 to 5, wherein the support (1) comprises at least one trench (77a, 77b) opening up on its front face (F1), the given wall (9) being a lateral wall of the trench (77a, 77b), the lateral wall making an angle of less than 90° with the front face.

7. The method according to any of the claims 1 to 6, further including between formation of the conducting layer and thinning of the support: - transfer a backing substrate (23) or a backing layer on the front face of the support (1).

8. The method according to any of the claims 1 to 7, wherein the support (1) comprises at least one trench (7a, 7b) opening up on its front face (F1) and wherein the support (1) comprises a first electronic chip (1.1) and a second electronic chip (1.2), the trench (7a, 7b) being located between the first chip and the second chip, the method further including after step b) and prior to step c): - a step of separating the first chip (1.1) from the second chip (1.2).

9. The method according to any of the claims 1 to 8, wherein the support (1) comprises at least one trench (7a, 7b) opening up on its front face (F1), the method further including between step a) and step b): - making conducting patterns (16a, 16b) in the conducting layer.

10. The method according to claim 9, including local removal of the conducting layer (14) so as to define discontiguous conducting elements along the lateral wall of the trench.

11. The method according to any of the claims 1 to 10, wherein the free conducting end is bent so as to bring the free end towards the back face.

12. The method according to any of the claims 1 to 11, bending being done at least partly by the addition of heat.

13. The method according to claim 12, wherein the conducting layer (14) is formed from a stack of at least one first material and at least one second material in contact with the first material and having a coefficient of thermal expansion higher than that of the first material.

14. The method according to any of the claims 1 to 13, wherein bending:
- includes mechanical pressurisation of at least one free conducting end against an inclined lateral flank of a cavity (53) against which the support (1) bears, and/or
- is done using a gripping device configured to heat the support (1) while applying it in contact with another support (60).

15. The method according to any of the claims 1 to 14, wherein the support (1) comprises at least one trench (7a, 7b) opening up on its front face (F1), the trench delimiting a chip (1.1) located in the support, the given wall being a lateral wall of the trench, the method further including the following after thinning:
- separate the chip by cutting along the trench,
- assemble the chip (1.1) on a structure provided with at least one conducting pad, such that the free projecting conducting end is brought into contact with the conducting pad.
